Europäisches Patentamt

European Patent Office

Office européen des brevets

(11) Veröffentlichungsnummer: **0 557 599 A1**

# (12) EUROPÄISCHE PATENTANMELDUNG

(21) Anmeldenummer: **92120597.7**

(51) Int. Cl.5: **H03F  1/32**

(22) Anmeldetag: **03.12.92**

(30) Priorität: **22.02.92 DE 4205491**

(43) Veröffentlichungstag der Anmeldung:
**01.09.93 Patentblatt  93/35**

(84) Benannte Vertragsstaaten:
**DE FR GB**

(71) Anmelder: **ASEA BROWN BOVERI AG**

**CH-5401 Baden(CH)**

(72) Erfinder: **Gehri, Patrick**
**Rosenstrasse 14**
**CH-5223 Riniken(CH)**
Erfinder: **Tomljenovic, Nenad**
**Stockackerstrasse 32**
**CH-5415 Nussbaumen(CH)**

(74) Vertreter: **Hetzer, Hans Jürgen et al**
**ABB Management AG**
**TEI-Immaterialgüterrecht Wiesenstrasse 26**
**CH-5401 Baden (CH)**

(54) **Verfahren zur Steuerung eines digitalen Pulsstufenmodulators PSM.**

(57) Bei einem Verfahren zur Steuerung eines digitalen Pulsstufenmodulators PSM, der eine Mehrzahl von n gleichartigen Schaltstufen (S1,..,Sn) mit einer festen Ausgangsspannung umfasst, wobei die Schaltstufen (S1,..,Sn) mittels eines in jeder Schaltstufe vorhandenen Schalters (S) nach Massgabe eines Niederfrequenz-Eingangssignals (NF) wahlweise in Serie geschaltet werden können, bei welchem Verfahren zur besseren Approximation der Eingangssignalspannung eine zusätzliche periodische, pulsdauermodulierte PDM-Spannung erzeugt und verwendet wird, wird eine Vergleichmässigung der Schaltvorgänge in den Schaltstufen dadurch erreicht, dass die PDM-Frequenz der periodischen PDM-Spannung nach Massgabe des zeitlichen Verlaufs der Eingangssignalspannung dynamisch verändert wird.

FIG. 1

EP 0 557 599 A1

## TECHNISCHES GEBIET

Die vorliegende Erfindung bezieht sich auf das Gebiet der Rundfunk-Sendetechnik. Sie betrifft ein Verfahren zur Steuerung eines digitalen Pulsstufenmodulators PSM, welcher eine Mehrzahl von n gleichartigen Schaltstufen mit einer festen Ausgangsspannung umfasst, wobei die Schaltstufen mittels eines in jeder Schaltstufe vorhandenen Schalters nach Massgabe eines Niederfrequenz-Eingangssignals wahlweise in Serie geschaltet werden können, bei welchem Verfahren

(a) der zulässige Bereich des Niederfrequenz-Eingangssignals in eine der Anzahl der Schaltstufen entsprechende Anzahl gleichartiger Spannungsstufen unterteilt wird;

(b) zu jedem Zeitpunkt die Anzahl der Spannungsstufen bestimmt wird, deren Summe eine Stufenspannung ergibt, welche gleich oder um weniger als eine Spannungsstufe grösser oder kleiner ist als die Eingangssignalspannung und die Eingangssignalspannung approximiert;

(c) zu jedem Zeitpunkt eine dieser Anzahl der Spannungsstufen entsprechende Anzahl Schaltstufen mittels entsprechender Schaltimpulse in Serie geschaltet wird; und

(d) zur besseren Approximation der Eingangssignalspannung eine zwischen der Eingangssignalspannung und der Stufenspannung auftretende Differenzspannung durch eine zur Stufenspannung addierte oder von der Stufenspannung subtrahierte periodische, pulsdauermodulierte PDM-Spannung verkleinert wird, nach deren Massgabe die Schaltstufen zusätzlich pulsdauermoduliert geschaltet werden.

Ein solches Verfahren ist z.B. aus der Druckschrift Brown Boveri Technik 5-85, S.235-240 (1985), bekannt.

## STAND DER TECHNIK

Es ist seit längerem bekannt, zur Verbesserung der Zuverlässigkeit und des Wirkungsgrades bei AM-Rundfunksendern halbleiterbestückte Pulsstufenmodulatoren einzusetzen, die eine Leistungsverstärkung des Niederfrequenz-Eingangssignals bewirken und zugleich die notwendige Anodenspannung für die Sendeendröhre zur Verfügung stehen.

Ein solcher PSM-Verstärker, wie er auch in der eingangs genannten Druckschrift erläutert wird, umfasst eine Mehrzahl von n gleichartigen Mittelspannungsquellen mit konstanter Ausgangsspannung, die mittels eines in der Ausgangsleitung jeder Stufe angeordneten Schalters wahlweise in Serie geschaltet werden können. Zur Verstärkung des analogen Niederfrequenz-Eingangssignals wird der maximale Bereich der Eingangssignalspannung in n gleich grosse Spannungsstufen unterteilt und zu jedem Zeitpunkt die Anzahl der Spannungstufen bestimmt, deren Summe eine Stufenspannung ergibt, die gleich oder um weniger als eine Spannungsstufe kleiner oder grösser ist als der Momentanwert der Eingangssignalspannung. Auf diese Weise wird die Eingangssignalspannung treppenstufenartig durch die Stufenspannung approximiert.

Wenn nun entsprechend der vorher bestimmten Anzahl der Spannungsstufen jeweils eine gleiche Anzahl von Schaltstufen ausgangsseitig in Serie geschaltet wird, ergibt sich am Ausgang des PSM-Verstärkers eine entsprechend verstärkte Stufenspannung, durch welche das gewünschte verstärkte Niederfrequenz-Eingangssignal approximiert werden kann.

Da die Approximation wegen der begrenzten Anzahl der Schaltstufen vergleichsweise grob ist, wird beim bekannten PSM-Verstärker weiterhin vorgesehen, die Differenz zwischen Eingangssignalspannung und Stufenspannung dadurch zu verkleinern, dass zur Stufenspannung eine periodische pulsdauermodulierte PDM-Spannung addiert oder von der Stufenspannung subtrahiert wird, deren Pulshöhe gerade einer Spannungsstufe entspricht. Entsprechend werden die Schaltstufen derart angesteuert, dass sich am Ausgang ein PDM-Signal addiert bzw. subtrahiert, dessen Pulshöhe gerade der Ausgangsspannung einer Schaltstufe entspricht.

Die Schaltstufen enthalten in der Regel als Schalter Leistungshalbleiter, deren Schaltfrequenz begrenzt ist. Aus diesem Grunde werden die Schaltstufen mit Vorteil so angesteuert, dass die notwendigen Schaltvorgänge auf alle Schaltstufen möglichst gleichmässig verteilt werden, wie dies z.B. in der Druckschrift EP-B1-0 124 765 vorgeschlagen worden ist.

Aus demselben Grunde sollte das zusätzliche PDM-Signal auch nicht durch pulsdauermodulierte Ansteuerung einer speziellen Schaltstufe erzeugt werden, sondern z.B. dadurch, dass (bei der Addition eines PDM-Signals) eine Schaltstufe zu Beginn eines PDM-Pulses eingeschaltet, und eine andere Schaltstufe am Ende des PDM-Pulses ausgeschaltet wird (bei der Subtraktion eines PDM-Signals sind die Verhältnisse genau umgekehrt: zu Beginn eines PDM-Pulses wird eine Schaltstufe ausgeschaltet, am Ende des Pulses eine andere eingeschaltet). Insgesamt ergibt sich dann für jede Schaltstufe eine tatsächliche mittlere Stufenschaltfrequenz, die sich aus einem von der PDM-Frequenz $f_P$ des PDM-Signals herrührenden Anteil und einem vom Modulationsfrequenzprodukt $m^*f_{NF}$ ($m$ = Modulationsgrad; $f_{NF}$ = Signalfrequenz der Eingangssignalspannung) stammenden Anteil zusammensetzt.

Wird nun dabei die PDM-Freguenz $f_P$ konstant gehalten, variiert die Stufenschaltfrequenz stark mit dem Modulationsfrequenzprodukt, was sich wegen der begrenzten Schaltfrequenzen der verwendeten Halbleiter im Betrieb nachteilig auswirkt.

## DARSTELLUNG DER ERFINDUNG

Es ist daher die Aufgabe der Erfindung, ein Verfahren zur Steuerung eines PSM-Verstärkers anzugeben, bei welchem die tatsächliche mittlere Stufenschaltfrequenz der Schaltstufen auf einem niedrigen Niveau weitgehend konstant gehalten wird.

Die Aufgabe wird bei einem Verfahren der eingangs genannten Art dadurch gelöst, dass

(e) die PDM-Frequenz der periodischen PDM-Spannung direkt oder indirekt nach Massgabe des zeitlichen Verlaufs der Eingangssignalspannung dynamisch verändert wird.

Eine bevorzugte Ausführungsform der Erfindung zeichnet sich dadurch aus, dass bei einer Signalfrequenz $f_{NF}$ und einem Modulationsgrad m der Eingangssignalspannung und einer vorgegebenen mittleren Stufenschaltfrequenz $f_s$ diePDM-Frequenz nach Massgabe der Gleichung

$$f_P = n^*f_s - n^*m^*f_{NF}$$

dem Modulationsfrequenzprodukt $m^*f_{NF}$ angepasst wird.

Damit wird erreicht, dass trotz einem stark variierenden Modulationsfrequenzprodukt die tatsächliche mittlere Stufenschaltfrequenz weitgehend konstant gehalten werden kann.

Besonders vorteilhaft ist es dabei, wenn gemäss einer weiteren Ausführungsform anstelle der aufwendigen direkten Bestimmung des Modulationsfrequenzprodukts $m^*f_{NF}$ als Mass für das Modulationsfrequenzprodukt einfacherweise ein numerisch gleitender Mittelwert aus der Anzahl der Schaltimpulse für die Schaltstufen nach Massgabe der Gleichung

$$m^*f_{NF} = I/(2^*n^*T_i)$$

gebildet wird, wobei $T_i$ die Mittelungs- bzw. Integrationszeit und I die Anzahl der in der Zeit $T_i$ auftretenden Schaltimpulse bezeichnet.

Gemäss einer weiteren bevorzugten Ausführungsform der Erfindung werden bei der dynamisch angepassten PDM-Spannung deren einzelne Impulse zeitsymmetrisch zur PDM-Periode gelegt, wobei

(a) zwei Zähler verwendet werden, welche jeweils bei einer Zahl überlaufen;

(b) jeder der beiden Zähler vor Beginn der Zählung mit einer bestimmten zugehörigen Preset-Zahl gesetzt wird, wobei die Preset-Zahl des ersten Zählers grösser ist als die Preset-Zahl des zweiten Zählers;

(c) beide Zähler mit derselben Clockfrequenz betrieben werden; und

(d) das Ueberlaufsignal des ersten Zählers zum Starten eines Impulses der PDM-Spannung und das Ueberlaufsignal des zweiten Zählers zum Beenden dieses Impulses verwendet wird.

Weitere Ausführungsformen ergeben sich aus den Unteransprüchen.

## KURZE BESCHREIBUNG DER ZEICHNUNG

Die Erfindung soll nachfolgend im Zusammenhang mit der Zeichnung anhand von Ausführungsbeispielen näher erläutert werden. Es zeigen

Fig. 1 den prinzipellen Aufbau eines bekannten PSM-Verstärkers, wie er beim Verfahren nach der Erfindung Verwendung findet;

Fig. 2a-d verschiedene Signalformen und Pulsfolgen ,wie sie bei der Verstärkung eines Niederfrequenz-Eingangssignals in einem PSM-Verstärker gemäss Fig. 1 auftreten;

Fig. 3 das Blockschaltbild einer möglichen Schaltung für die Erzeugung einer dynamisch angepassten bzw. ausgeregelten PDM-Frequenz nach dem erfindungsgemässen Verfahren;

Fig. 4 das Prinzipschaltbild einer Schaltung zur Erzeugung eines zeitsymmetrischen PDM-Impulses gemäss einer bevorzugten Ausführungsform des Verfahrens nach der Erfindung; und

Fig. 5a-c Diagramme zur Erläuterung der Methode, nach welcher die Preset-Zahlen X und Y für die Schaltung gemäss Fig. 4 festgelegt werden.

WEGE ZUR AUSFÜHRUNG DER ERFINDUNG

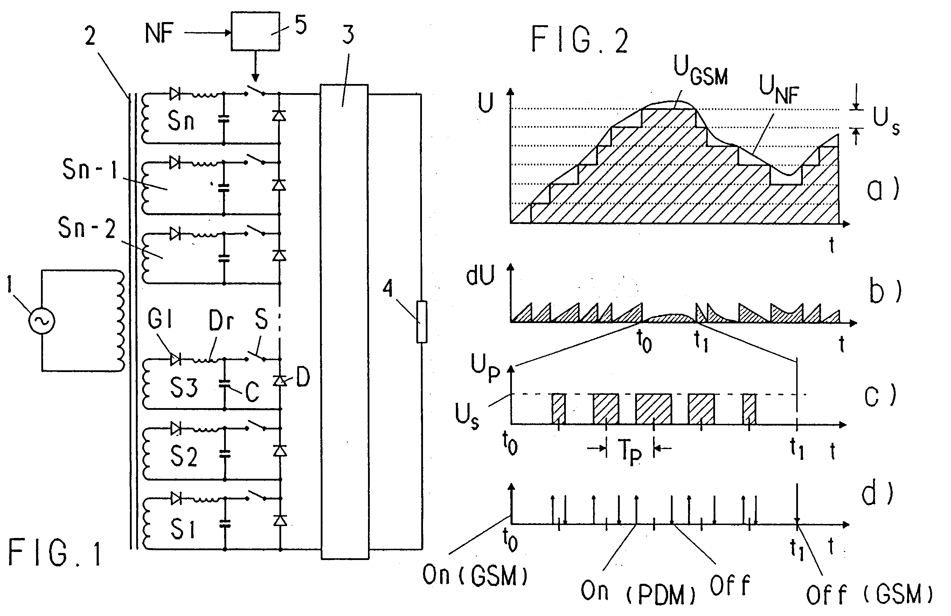

In Fig. 1 ist der prinzipielle Aufbau eines digital arbeitenden Pulsstufenmodulations- oder PSM-Verstärkers wiedergegeben, wie er aus dem Stand der Technik bekannt ist. Der Verstärker umfasst eine Mehrzahl von n gleichartigen Schaltstufen S1,..,Sn, die jeweils als schaltbare Mittelspannungsquellen aufgebaut sind und einen Gleichrichter Gl, sowie zur Glättung eine Drossel Dr und einen Kondensator C enthalten. Ueber einen gesteuerten Schalter S und eine Kaskade von Dioden D können die Schaltstufen S1,..,Sn wahlweise mit ihrer konstanten Ausgangsspannung in Serie geschaltet werden.

Die Eingangsspannung der Schaltstufen S1,..,Sn stammt aus entsprechenden galvanisch getrennten Sekundärwicklungen eines Netztransformators 2, dessen Primärwicklung an eine Wechselspannungsquelle, in der Regel das Netz, angeschlossen ist. Die Schalter S der Schaltstufen S1,..,Sn werden von einer Schaltstufensteuerung 5 angesteuert, die nach Massgabe eines am Eingang anliegenden Niederfrequenz-Eingangssignals NF so viele Schaltstufen einschaltet wie zur Approximation der Eingangssignalspannung durch eine Stufenspannung notwendig sind.

Am Ausgang des Verstärkers ist vor einer Last 4 ein Tiefpassfilter 3 angeordnet, welches das digital approximierte Ausgangssignal derart glättet, dass sich näherungsweise eine verstärkte Form des Niederfrequenz-Eingangssignals NF ergibt.

Zur Verbesserung der Approximation ist darüberhinaus die Ueberlagerung eines pulsdauermodulierten Zusatzsignals zur Stufenspannung vorgesehen, die anhand der Fig. 2a-d ohne Beschränkung der Allgemeinheit für den speziellen Fall der Addition eines PDM-Signals erläutert werden soll: Wie in Fig. 2a dargestellt und durch die punktierten Linien angedeutet, ist der zulässige Bereich des Niederfrequenz-Eingangssignals NF in eine Mehrzahl von insgesamt n (n = Anzahl der Schaltstufen) gleichartigen Spannungsstufen $U_s$ unterteilt.

Der tatsächliche zeitliche Verlauf der dem Niederfrequenz-Eingangssignal NF zugeordneten Eingangssignalsspannung $U_{NF}$ wird dann zunächst grob approximiert durch eine Stufenspannung $U_{GSM}$, welche als ganzzahliges Vielfaches einer Spannungsstufe $U_s$ gleich oder um weniger als eine Spannungsstufe $U_s$ kleiner ist als die Eingangssignalspannung $U_{NF}$. Aufgrund der endlichen Grösse von n ergibt sich zwischen der Eingangssignalspannung $U_{NF}$ und der Stufenspannung $U_{GSM}$ eine Differenzspannung $dU = U_{NF} - U_{GSM}$, die für das Beispiel aus Fig. 2a in Fig. 2b wiedergegeben ist.

Zur Feinapproximation wird nun die Differenzspannung dU durch eine periodische pulsdauermodulierte PDM-Spannung $U_P$ angenähert, wie dies in Fig. 2c für einen herausgegriffenen Zeitabschnitt, der zwischen den Zeitpunkten $t_0$ und $t_1$ liegt, gezeigt ist. Die PDM-Spannung $U_P$ besitzt dabei eine PDM-Periode $T_P$ und die Höhe ihrer Pulse entspricht einer Spannungsstufe $U_s$. Die PDM-Spannung $U_P$ wird zur Stufenspannung $U_{GSM}$ addiert und erlaubt auf diese Weise selbst bei einer geringen Anzahl n von Schaltstufen bzw. Spannungsstufen eine vergleichsweise gute Annäherung der stetigen Eingangssignalspannung $U_{NF}$.

Die Stufenspannung $U_{GSM}$ und die überlagerte PDM-Spannung $U_P$ werden nun durch eine entsprechende Ansteuerung der Schaltstufen S1,..,Sn in verstärkter Form dargestellt, wobei aus der Schaltstufensteuerung 5 die notwendigen Schaltbefehle für das Einschalten (On) und das Ausschalten (Off) der jeweiligen Schalter S in den Stufen an die Schalter S gegeben werden. Für den in Fig. 2c dargestellten Zeitabschnitt zwischen $t_0$ und $t_1$ sind diese Schaltbefehle in Form von nach oben (On) bzw. nach unten (Off) gerichteten Pfeilen in Fig. 2d wiedergegeben, wobei die beiden längeren Pfeile (bei $t_0$ und $t_1$) das dauerhafte Ein- bzw. Ausschalten einer ganzen Stufe, die kürzeren, dazwischenliegenden Pfeile das pulsdauermodulierte Ein- und Ausschalten einer Stufe symbolisieren.

An dieser Stelle sei ausdrücklich darauf hingewiesen, dass in jedem Fall (d.h. hinsichtlich $U_{GSM}$ und $U_P$) nicht notwendig diejenige Stufe wieder ausgeschaltet werden muss, die vorher gerade eingeschaltet worden ist, sondern dass vielmehr bewusst bei jedem Schaltvorgang andere Schaltstufen eingesetzt werden, um die Belastung der Schaltstufen zu vergleichmässigen. Da alle Schaltstufen äquivalent sind, kann also beispielsweise ein PDM-Puls erzeugt werden, indem zu Beginn des Pulses eine noch nicht eingeschaltete Schaltstufe, z.B. S1, eingeschaltet, am Ende des Pulses aber eine andere, bereits eingeschaltete Schaltstufe, z.B. S4, ausgeschaltet wird. An dieser Stelle sei noch einmal bemerkt, dass im Falle der Subtraktion eines PDM-Signals die Verhältnisse genau umgekehrt sind, d.h. zu Beginn eines Pulses wird eingeschaltete Schaltstufe aus-, am Ende des Pulses eine andere, nicht eingeschaltete Stufe eingeschaltet.

Unter dieser Voraussetzung einer weitgehenden Gleichverteilung der Schaltvorgänge auf alle n Schaltstufen S1,..,Sn lässt sich für die einzelnen Schaltstufen eine mittlere Stufenschaltfrequenz $f_s$ angeben, die sich wie folgt zusammensetzt:

(1)     $f_s = f_P/n + m^* f_{NF}$

wobei $f_P = 1/T_P$ die PDM-Frequenz bezeichnet, und $m^*f_{NF}$ das sogenannte Modulationsfrequenzprodukt aus dem Modulationsgrad m (m = Verhältnis der Amplitude von $U_{NF}$ zum Maximalwert $(n^*U_s)/2)$ und der Signalfrequenz $f_{NF}$ des Niederfrequenz-Eingangssignals NF.

Um nun die mittlere Stufenschaltfrequenz auf einem vorgegebenen Wert möglichst konstant zu halten, wird gemäss einer bevorzugten Ausführungsform der Erfindung die PDM-Frequenz $f_P$ mit dem Modulationsfrequenzprodukt dynamisch so verändert, dass $f_s \approx$ const. gilt. Die Auflösung der Gleichung (1) nach $f_P$ ergibt dann:

$$(2) \qquad f_P = (f_s - m^*f_{NF})^*n = n^*f_s - n^*m^*f_{NF} .$$

Da wegen der Voraussetzung $f_s \approx$ const. der Anteil $n^*f_s$ konstant ist, variiert $f_P$ proportional zum Modulationsfrequenzprodukt $m^*f_{NF}$.

Die Bestimmung des Modulationsfrequenzproduktes ist nicht ganz einfach. Sie kann aber umgangen werden, wenn man berücksichtigt, dass der Term $n^*m^*f_{NF}$ direkt proportional zur maximalen Steigung der Eingangssignalsspannung $U_{NF}$ in einer Periode ist. Einen proportionalen Wert zu dieser Steigung erhält man durch eine numerisch gleitende Mittelwertbildung über die Anzahl der Schaltimpulse, die zur Darstellung der verstärkten Form der Stufenspannung $U_{GSM}$ an die Schaltstufen S1,..,Sn abgegeben werden.

Die Herleitung einer entsprechenden Formel zur Bestimmung der PDM-Frequenz $f_P$ als Funktion der mittleren Anzahl von On/Off-Impulsen geht von folgendem Ansatz aus: In einer vollen Periode des Niederfrequenz-Eingangssignals NF treten (bei m = 1) $2^*n$ On/Off-Impulse auf (jede Stufe wird einmal ein- und ausgeschaltet). Bei m < oder > 1 sind es entsprechend $m^*2^*n$ On/Off-Impulse. Während einer vorgegebenen Mittelungs- bzw. Integrationszeit $T_i$ ergeben sich somit im Mittel

$$(2a) \qquad I = m^*2^*n^*f_{NF}^*T_i$$

On/Off- bzw. Schaltimpulse. Nach $n^*m^*f_{NF}$ aufgelöst und in Gleichung (2) eingesetzt ergibt sich für die PDM-Frequenz

$$(2b) \qquad f_{NF} = n^*f_s - I/(2^*T_i).$$

Mit Kenntnis der Stufenschaltfrequenz $f_s$ und der Stufenzahl n, sowie einer geigneten Wahl der Integrationszeit $T_i$ für die Mittelwertbildung kann auf diese Weise gemäss einer bevorzugten Ausführungsform des erfindungsgemässen Verfahrens die PDM-Frequenz $f_P$ dynamisch auf numerischem Wege dem Modulationsfrequenzprodukt $m^*f_{NF}$ angepasst werden. Die Anpassung der PDM-Frequenz $f_P$ an das Modulationsfrequenzprodukt kann dabei kontinuierlich oder diskret in mehreren Stufen erfolgen. Natürlich ist auch der Grenzfall $f_P = 0$ erlaubt.

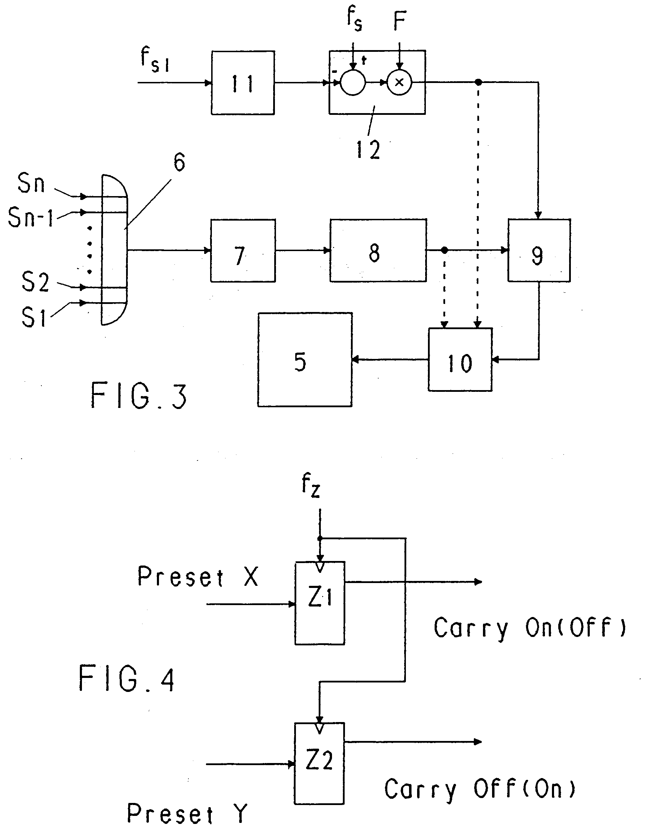

Das Blockschaltbild einer möglichen Schaltung zur Realisierung der beschriebenen dynamischen Nachführung umfasst gemäss Fig. 3 ein ODER-Gatter 6, über dass die On/Off-Schaltimpulse aus den einzelnen Schaltstufen S1,..,Sn auf den Eingang eines Mittelwertbildners 7 gegeben werden. Der dort errechnete Mittelwert I der On/Off-Impulse wird auf den Eingang einer nachfolgenden Kennliniensteuerung 8 gegeben, wo gemäss Gleichung (2b) aus dem Wert I ein entsprechender Steuerwert für die PDM-Frequenz $f_P$ abgeleitet und zur Steuerung an einen Oszillator 10 weitergegeben wird, welcher die PDM-Frequenz $f_P$ erzeugt und an die Schaltstufensteuerung 5 abgibt. Im Falle einer kontinuierlichen Nachführung sind Kennliniensteuerung 8 und Oszillator 10 direkt miteinander verbunden (gestrichelte Verbindung). Im Falle diskreter Stufen dagegen ist beispielsweise eine Umschaltlogik 9 zwischengeschaltet, die das Ergebnis aus der Kennliniensteuerung 8 mit fest vorgegebenen Werten vergleicht und bei Ueberschreiten dieser Werte jeweils eine neue Festfrequenz im Oszillator 10 einstellt.

Während die Blöcke 6, 7 und 8 eine Schaltung zur Steuerung der PDM-Frequenz $f_P$ darstellen, kann die PDM-Frequenz alternativ auch ausgeregelt werden. Entsprechende Schaltungsteile sind im oberen Teil der Fig. 3 dargestellt und umfassen gleichfalls einen Mittelwertbildner 11 und eine nachgeschaltete Regelungsschaltung 12, die wiederum wahlweise direkt (gestrichelte Verbindung) oder über die Umschaltlogik 9 auf den Oszillator 10 einwirken kann. Die Stufenschaltfrequenz wird gemessen und ihr Istwert $f_{si}$ im Mittelwertbildner 11 gemittelt und anschliessend in der Regelungsschaltung 12 mit der vorgegebenen mittleren Stufenschaltfrequenz $f_s$ verglichen. Die Differenz beider Grössen ist dann ein Mass dafür, ob die PDM-Frequenz $f_P$ erhöht oder vermindert werden muss. Sie wird mit einem Normierungsfaktor F multipliziert und dann zur Regelung des Oszillators 10 verwendet. Diese Art der Regelung hat den besonderen Vorteil, das die PDM-Frequenz $f_P$ nicht explizit bekannt sein muss. Sie wird vielmehr automatisch dem Sollwert nachgeregelt (P-Regler). Andererseits ist zu berücksichtigen, dass die Regelstrecke eine Totzeit aufweist, so dass die Regelung dem aktuellen Wert immer nachhinkt.

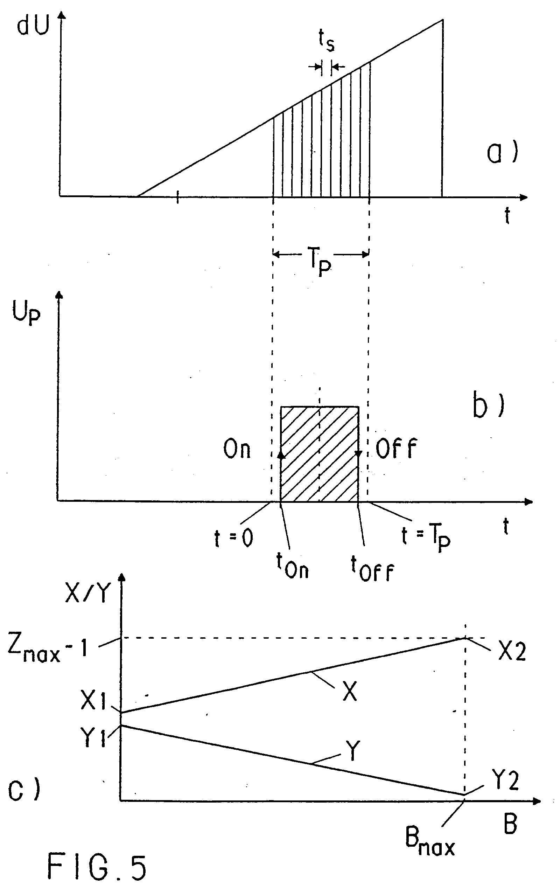

Gemäss einer weiteren bevorzugten Ausführungsform der Erfindung wird eine PDM-Spannung $U_P$ verwendet, deren einzelne Impulse zeitsymmetrisch zur PDM-Periode $T_P$ liegen. Eine bevorzugte, in Digitaltechnik realisierbare Methode zur Erzeugung einer solchen PDM-Spannung soll nachfolgend anhand der Figuren 4 und 5a-c erläutert werden:

In Fig. 5a ist in Entsprechung zur Fig. 2b ein Abschnitt der Differenzspannung dU dargestellt, der sich als Differenz zwischen der Eingangssignalsspannung $U_{NF}$ und der Stufenspannung $U_{GSM}$ ergibt. Die Fläche dieser Differenzspannung ist positiv, da hier wiederum der spezielle Fall der Addition des PDM-Signals angenommen wird. Die Fläche soll, wie bereits vorher erwähnt, durch die PDM-Spannung $U_P$ möglichst genau ausgefüllt werden. Dazu wird die Differenzspannung gemäss Fig. 5a zu diskreten Zeitpunkten im Abstand einer Abtastperiode $t_s$ abgetastet. Die zugehörige Abtastfrequenz $1/t_s$ beträgt dabei ein ganzzahliges Vielfaches der PDM-Frequenz $f_P$. Die Addition der letzten k Abtastwerte ergibt eine zur Spannungsfläche der Differenzspannung dU proportionale Zahl B, aus welcher gemäss dem in Fig. 5c gezeigten Diagramm zwei Preset-Zahlen X und Y (< X) für zwei Zähler Z1 und Z2 (Fig. 4) erzeugt werden, mit deren Hilfe die Zeitpunkte $t_{On}$ und $t_{Off}$ für den Anfang bzw. das Ende des gewünschten zeitsymmetrischen PDM-Pulses (Fig. 5b) festgelegt werden.

Die beiden Zähler Z1 und Z2 werden mit derselben Clockfrequenz $f_z$ betrieben und laufen jeweils bei derselben Zahl $Z_{max}$ über. Am Anfang der PDM-Periode (t = 0 in Fig. 5b) wird der erste Zähler Z1 auf die erste Preset-Zahl X, der zweite Zähler Z2 auf die zweite Preset-Zahl Y gesetzt. Die beiden Zähler zählen dann synchron mit der Clockfrequenz $f_z$ aufwärts. Sobald der erste Zähler Z1 überläuft, wird (bei $t_{On}$) über seinen Carry-Ausgang ein On-Befehl für den PDM-Impuls (dies entspricht einem Off-Befehl, wenn das PDM-Signal subtrahiert werden soll) abgegeben. Da X > Y, muss der zweite Zähler Z2 länger als Z1 zählen, bis er überläuft. Der zweite Zähler gibt also entsprechend später (bei $t_{Off}$) an seinem Carry-Ausgang einen Off-Befehl für den PDM-Impuls (dies entspricht einem On-Befehl, wenn das PDM-Signal subtrahiert werden soll) ab.

Durch geeignete Wahl der Preset-Zahlen X und Y (in Abhängigkeit von der momentanen PDM-Frequenz $f_P$), der Länge der Zähler Z1 , Z2 und der Clockfrequenz $f_z$ gemäss Fig. 5c kann so eine bezüglich der PDM-Periode zeitsymmetrische PDM-Spannung $U_P$ erzeugt werden. Die Wahl der Zahlen ergibt sich wie folgt:

Damit der bei Beginn der zugehörigen PDM-Periode gestartete Zähler Z1 bei $t_{On}$ überläuft, muss für die erste Preset-Zahl X gelten

(3)    $X = Z_{max} - t_{On}{}^* f_z$ .

Für den zweiten Zähler Z2 und den Abschaltzeitpunkt $t_{Off}$ gilt analog

(4)    $Y = Z_{max} - t_{Off}{}^* f_z$ .

Weiterhin gilt für die verschiedenen Zeiten im Verhältnis zu den Spannungsflächen:

$$(5) \qquad \frac{t_{Off} - t_{On}}{T_P} = \frac{B}{B_{max}} \; ,$$

wobei B die Summe der letzten k Abtastwerte und $B_{max}$ den maximal möglichen Wert von B darstellen. Massgebend sind hier nicht die absoluten Werte B und $B_{max}$, sondern nur deren Verhältnis.

Für den Grenzfall $t_{On} = t_{Off} = T_P/2$ (unendlich kurzer PDM-Impuls) lauten die Preset-Zahlen für die beiden Zähler Z1, Z2

(6)    $X1 = Z_{max} - f_z{}^*(T_P/2) + 1$

und

(7)    $Y1 = Z_{max} - f_z{}^*(T_P/2) - 1$ ;

die Zahlen +1 und -1 sind hier deshalb hinzugefügt, weil es keinen Sinn macht, gleichzeitig einen On- und Off-Befehl zu generieren.

Für den zweiten Grenzfall $t_{On}$ = 0, $t_{Off}$ = $T_P$ (der PDM-Puls dauert die ganze PDM-Periode) gilt:

(8) $\quad$ X2 = $Z_{max}$ - 1

und

(9) $\quad$ Y2 = $Z_{max}$ - $f_z^*T_P$ + 1 ;

auch hier sind die Zahlen +1 und -1 vorgesehen, um einen gegenüber der Nachbarperiode eindeutig abgrenzbaren PDM-Impuls zu erhalten.

Mit den in (6) bis (9) aufgeführten Randwerten ergeben sich die in Fig. 5c dargestellten linearen Beziehungen zwischen X bzw. Y und B, die den folgenden Formeln genügen:

(10) $\quad$ X = X1 + (X2-X1)$^*$B/$B_{max}$

und

(11) $\quad$ Y = Y1 - (Y1-Y2)$^*$($B_{max}$-B)/$B_{max}$.

Die gewünschte Genauigkeit der Zeitpunkte $t_{On}$ und $t_{Off}$ bestimmt die Länge (Bitlänge) der eingesetzten Zähler Z1 und Z2. Die nötige Clockfrequenz $f_z$ ergibt sich aus der Bitlänge und der maximal vorkommenden PDM-Periode $T_P$. Als Beispiel seien ein $Z_{max}$ = 512 (Bitlänge: 9 Bit) und eine maximale PDM-Periode von $T_P$ = 30 $\mu$s angegeben, was zu einer Clockfrequenz von $f_z$ = 32 MHz führt. Die PDM-Perioden können z.B. dynamisch in Stufen umschaltbar sein zwischen $T_P$ = 0, 10 $\mu$s, 20 $\mu$s und 30 $\mu$s. Als Abtastrate sei eine Frequenz von 1/$t_s$ = 100 kHz genannt, sodass PDM-Frequenzen $f_P$ von 100 kHz/N (N = ganze Zahl) denkbar sind.

Obgleich die Art der Pulserzeugung hier nur für den Fall der Addition eines PDM-Signals beschrieben worden ist, kann sie selbstverständlich in entsprechender Abwandlung auch für den äquivalenten Fall der Subtraktion eines PDM-Signals verwendet werden.

Insgesamt ergibt sich mit der Erfindung ein Verfahren zur Steuerung eines PSM-Verstärkers, welches zu einer Vergleichmässigung der Schaltvorgänge in den Schaltstufen führt und leicht in digitaler Schaltungstechnik realisiert werden kann.

## Patentansprüche

1. Verfahren zur Steuerung eines digitalen Pulsstufenmodulators PSM, welcher eine Mehrzahl von n gleichartigen Schaltstufen (S1,..,Sn) mit einer festen Ausgangsspannung umfasst, wobei die Schaltstufen (S1,..,Sn) mittels eines in jeder Schaltstufe vorhandenen Schalters (S) nach Massgabe eines Niederfrequenz-Eingangssignals (NF) wahlweise in Serie geschaltet werden können, bei welchem Verfahren

(a) der zulässige Bereich des Niederfrequenz-Eingangssignals (NF) in eine der Anzahl der Schaltstufen (S1,..,Sn) entsprechende Anzahl gleichartiger Spannungsstufen ($U_s$) unterteilt wird;

(b) zu jedem Zeitpunkt die Anzahl der Spannungsstufen ($U_s$) bestimmt wird, deren Summe eine Stufenspannung ($U_{GSM}$) ergibt, welche gleich oder um weniger als eine Spannungsstufe ($U_s$) grösser oder kleiner ist als die Eingangssignalspannung ($U_{NF}$) und die Eingangssignalspannung ($U_{NF}$) approximiert;

(c) zu jedem Zeitpunkt eine dieser Anzahl der Spannungsstufen entsprechende Anzahl Schaltstufen (S1,..,Sn) mittels entsprechender Schaltimpulse in Serie geschaltet wird; und

(d) zur besseren Approximation der Eingangssignalspannung ($U_{NF}$) eine zwischen der Eingangssignalspannung ($U_{NF}$) und der Stufenspannung ($U_{GSM}$) auftretende Differenzspannung (dU) durch eine zur Stufenspannung ($U_{GSM}$) addierte oder von der Stufenspannung ($U_{GSM}$) subtrahierte periodische, pulsdauermodulierte PDM-Spannung ($U_P$) verkleinert wird, nach deren Massgabe die Schaltstufen (S1,..,Sn) zusätzlich pulsdauermoduliert geschaltet werden;

dadurch gekennzeichnet, dass

(e) die PDM-Frequenz ($f_P$) der periodischen PDM-Spannung ($U_P$) direkt oder indirekt nach Massgabe des zeitlichen Verlaufs der Eingangssignalspannung ($U_{NF}$) dynamisch verändert wird.

**2.** Verfahren nach Anspruch 1, dadurch gekennzeichnet, dass bei einer Signalfrequenz $f_{NF}$ und einem Modulationsgrad m der Eingangssignalspannung ($U_{NF}$) und einer vorgegebenen mittleren Stufenschaltfrequenz $f_s$ die PDM-Frequenz ($f_P$) nach Massgabe der Gleichung

$$f_P = n^*f_s - n^*m^*f_{NF}$$

dem Modulationsfrequenzprodukt $m^*f_{NF}$ angepasst wird.

**3.** Verfahren nach Anspruch 2, dadurch gekennzeichnet, dass als Mass für das Modulationsfrequenzprodukt $m^*f_{NF}$ ein numerisch gleitender Mittelwert aus der Anzahl der Schaltimpulse für die Schaltstufen (S1,..,Sn) nach Massgabe der Gleichung

$$m^*f_{NF} = I/(2^*n^*T_i)$$

gebildet wird, wobei $T_i$ die Mittelungs- bzw. Integrationszeit und I die Anzahl der in der Zeit $T_i$ auftretenden Schaltimpulse bezeichnet.

**4.** Verfahren nach Anspruch 1, dadurch gekennzeichnet, dass bei einer vorgegebenen mittleren Stufenschaltfrequenz ($f_s$) die PDM-Frequenz ($f_P$) nach Massgabe der Differenz zwischen der vorgegebenen mittleren Stufenschaltfrequenz ($f_s$) und einer tatsächlich gemessenen mittleren Stufenschaltfrequenz ($f_{s,m}$) nachgeregelt wird.

**5.** Verfahren nach einem der Ansprüche 2 bis 4, dadurch gekennzeichnet, dass die Anpassung bzw. Nachregelung der PDM-Frequenz ($f_P$) kontinuierlich erfolgt.

**6.** Verfahren nach einem der Ansprüche 2 bis 4, dadurch gekennzeichnet, dass die Anpassung bzw. Nachregelung der PDM-Frequenz ($f_P$) in diskreten Stufen erfolgt.

**7.** Verfahren nach einem der Ansprüche 1 bis 6, dadurch gekennzeichnet, dass eine PDM-Spannung ($U_P$) verwendet wird, deren einzelne Impulse zeitsymmetrisch zur PDM-Periode ($T_P$) liegen.

**8.** Verfahren nach Anspruch 7, dadurch gekennzeichnet, dass zur Erzeugung der zeitsymmetrischen Impulse der PDM-Spannung ($U_P$)
(a) zwei Zähler (Z1, Z2) verwendet werden, welche jeweils bei einer Zahl ($Z_{max}$) überlaufen;
(b) jeder der beiden Zähler (Z1, Z2) vor Beginn der Zählung mit einer bestimmten zugehörigen Preset-Zahl (X bzw. Y) gesetzt wird, wobei die Preset-Zahl (X) des ersten Zählers (Z1) grösser ist als die Preset-Zahl (Y) des zweiten Zählers (Z2);
(c) beide Zähler (Z1, Z2) mit derselben Clockfrequenz ($f_z$) betrieben werden; und
(d) das Ueberlaufsignal des ersten Zählers (Z1) zum Starten eines Impulses der PDM-Spannung ($U_P$) und das Ueberlaufsignal des zweiten Zählers (Z2) zum Beenden dieses Impulses verwendet wird.

**9.** Verfahren nach Anspruch 8, dadurch gekennzeichnet, dass
(a) die Differenzspannung (dU) mit einer Abtastfrequenz abgetastet wird, welche ein ganzzahliges Vielfaches der PDM-Frequenz ($f_P$) beträgt, und die letzten k (k = ganze Zahl) Abtastwerte aufsummiert werden; und
(b) die Preset-Zahlen X bzw. Y nach Massgabe der folgenden Gleichungen bestimmt werden:

$$X = X1 + (X2-X1)^*B/B_{max}$$

und

$$Y = Y1 - (Y1-Y2)^*(B_{max}-B)/Bmax ,$$

wobei B die tatsächliche Summe der letzten k Abtastwerte, und $B_{max}$ die maximal mögliche Summe der letzten k Abtastwerte bedeuten, und X1, X2 sowie Y1, Y2 durch die folgenden Gleichungen gegeben sind:

$X1 = Z_{max} - f_z{}^*T_P/2 + 1$ ;

$X2 = Z_{max} - 1$ ;

$Y1 = Z_{max} - f_z{}^*T_P/2 - 1$ ; und

$Y2 = Z_{max} - f_z{}^*T_P + 1$ .

FIG. 2

FIG. 1

FIG.3

FIG.4

FIG.5

Europäisches
Patentamt

**EUROPÄISCHER RECHERCHENBERICHT**

Nummer der Anmeldung

EP 92 12 0597

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5 ) |
|---|---|---|---|
| A,D | BROWN BOVERI TECHNIK Mai 1985, Seiten 235 - 240 WOLFRAM SCHMINKE 'Hochleistungsmodulator in PSM-Technik für 500-kW-Kurzwellen und 600-kW-Mittelwellensender' * Seite 237, Spalte 2, Zeile 1 - Spalte 3, Zeile 11; Abbildungen 1,2 * --- | 1 | H03F1/32 |
| A | EP-A-0 327 682 (LICENTIA PATENT-VERWALTUNG-GMBH) * Seite 4, Zeile 7 - Seite 5, Zeile 19; Abbildung 1 * --- | 1,4 | |
| A | EP-A-0 329 967 (AEG OLYMPIA AKTIENGESELLSCHAFT) * Seite 3, Zeile 7 - Seite 4, Zeile 10; Abbildung 1 * ----- | 1 | |
| | | | **RECHERCHIERTE SACHGEBIETE (Int. Cl.5 )** |
| | | | H03F |

Der vorliegende Recherchenbericht wurde für alle Patentansprüche erstellt

| Recherchenort | Abschlußdatum der Recherche | Prüfer |
|---|---|---|
| DEN HAAG | 03 JUNI 1993 | WALDORFF U. |

**KATEGORIE DER GENANNTEN DOKUMENTE**

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus andern Gründen angeführtes Dokument
..........................................................................................
& : Mitglied der gleichen Patentfamilie, übereinstimmendes
    Dokument